# EUROPÄISCHE PATENTSCHRIFT

(11) **EP 1 527 011 B1**
(45) Veröffentlichungstag und Bekanntmachung des Hinweises auf die Patenterteilung: **17.03.2010**
(21) Anmeldenummer: 03735274.7
(22) Anmeldetag: 06.05.2003
(51) Int. Cl.: B81C 1/00

(54) **SCHICHTSYSTEM MIT EINER SILIZIUMSCHICHT UND EINER PASSIVIERSCHICHT, VERFAHREN ZUR ERZEUGUNG EINER PASSIVIERSCHICHT AUF EINER SILIZIUMSCHICHT UND DEREN VERWENDUNG**
LAYER SYSTEM WITH A SILICON LAYER AND A PASSIVATION LAYER, METHOD FOR PRODUCTION OF A PASSIVATION LAYER ON A SILICON LAYER AND USE THEREOF
SYSTEME EN COUCHES COMPORTANT UNE COUCHE SILICIUM ET UNE COUCHE DE PASSIVATION, PROCEDE DE FABRICATION D'UNE COUCHE DE PASSIVATION SUR UNE COUCHE SILICIUM ET UTILISATION

(30) Priorität: 30.07.2002 DE 10234589
(43) Veröffentlichungstag der Anmeldung: 04.05.2005
(73) Patentinhaber: ROBERT BOSCH GMBH, 70442 Stuttgart (DE)
(72) Erfinder: URBAN, Andrea, 70563 Stuttgart (DE); LAERMER, Franz, 71263 Weil der Stadt (DE); BREITSCHWERDT, Klaus, 70794 Filderstadt (DE)
(86) Internationale Anmeldenummer: PCT/DE2003/001436
(87) Internationale Veröffentlichungsnummer: WO 2004/016546

(56) Entgegenhaltungen:
- DE-A- 19 919 469
- DE-A1- 19 847 455
- US-A- 4 576 834
- US-A- 5 116 460
- OHARA J, KANO K, TAKEUCHI Y, OHYA N, OTSUKA Y, AKITA S: "A new deep reactive ion etching process by dual sidewall protection" PROCEEDINGS IEEE THIRTEENTH ANNUAL INTERNATIONAL CONFERENCE ON MICRO ELECTRO MECHANICAL SYSTEMS, MIYAZAKI, JAPAN, 23. - 27. Januar 2000, Seiten 277-282, XP002283554

## Beschreibung

Die Erfindung betrifft ein Schichtsystem mit einer Siliziumschicht und einer Passivierschicht, ein Verfahren zur Erzeugung einer Passivierschicht auf einer Siliziumschicht und Verwendung dieses Schichtsystems oder dieses Verfahrens nach Gattung der unabhängigen Ansprüche.

### Stand der Technik

Bei einem beispielsweise aus DE 44 20 962 C2 bekannten Verfahren zur Herstellung freitragender MEMS-Strukturen in Silizium (MEMS = "mikroelektromechanical structures") durch Kombination anisotroper und isotroper Ätztechniken werden zunächst sogenannte Trenchgräben oder tiefe Strukturen mit senkrechten Seitenwänden mittels eines reaktiven Plasmas anisotrop in ein Siliziumsubstrat eingeätzt. Nach Erreichen der gewünschten Ätztiefe wird dann nach einem länger andauernden Passivierschritt zur Abscheidung eines teflonartigen Films ein länger andauernder Ätzschritt durchgeführt, bei dem zunächst mittels Ionenbeschuss der Ätzgrund des Trenchgraben von einem gebildeten Teflonpolymer frei geräumt, und anschließend eine isotrope Unterätzung von zu erzeugenden freitragenden MEMS-Strukturen vorgenommen. Die senkrechten Seitenwände der Trenchgräben bleiben während dieser isotropen Unterätzung durch den zuvor aufgebrachten teflonartigen Film vor einem Ätzangriff geschützt. Die isotrope Unterätzung der erzeugten MEMS-Strukturen schreitet gemäß DE 44 20 962 C2 in dem Substratmaterial Silizium rein zeitkontrolliert voran.

Zur Abscheidung des teflonartigen Films wird bevorzugt ein Fluorkohlenwasserstoff mit möglichst niedrigem Fluor-zu-Kohlenstoff-Verhältnis von vorzugsweise 2:1 eingesetzt, wozu sich besonders Fluorkohlenwasserstoffe wie C₄F₆, C₅F₈, C₄F₈ oder C₃F₆ eignen. Zur Ätzung von Silizium wird bevorzugt ein an sich isotrop ätzendes, Fluorradikale lieferndes Prozessgas wie SF₆ herangezogen.

In DE 198 47 455 A1 ist vorgeschlagen worden, bei einem isotropen Unterätzen über vergrabene Oxidschichten eine vertikale Begrenzung der isotropen Unterätzung vorzunehmen. Insbesondere wird dort ein Ätzangriff auf die MEMS-Strukturen durch ein Zwischenoxid, das die MEMS-Struktur von einer Opferschicht aus Silizium trennt, verhindert. Daneben ist dort beschrieben, dass die isotrope Unterätzung statt mit Hilfe von Fluorradikalen aus einer Plasmaentladung auch unter Verwendung von spontan und plasmalos siliziumätzenden Fluorverbindungen wie XeF₂, ClF₃ oder BrF₃ erfolgen kann. Diese Verbindungen spalten nach Adsorption und Chemiesorption auf einer Siliziumoberfläche spontan Fluorradikale ab, was zu einem isotropen Ätzabtrag des Siliziums durch Bildung von Siliziumtetrafluorid führt. Dabei ist gleichzeitig eine sehr hohe Selektivität gegenüber Nichtsiliziummaterialien wie teflonartigen oder anderweitig zusammengesetzten Passivierschichten gegeben. Insbesondere wird Fotolack von ClF₃ praktisch nicht messbar angegriffen, so dass einerseits eine Passivierung von nicht zu ätzenden Teilen eines Siliziumwafers besonders leicht möglich ist, andererseits aber auch schon sehr dünne Passivierschichten genügen, um einen vollständigen Schutz vor einem Ätzangriff zu gewährleisten. Vielfach ist das auf Siliziumoberflächen in der Regel ohnehin vorhandene sogenannte "native" Siliziumoxid bereits in der Lage minutenlang einem Chlortrifluorid-Angriff standhalten, ohne dass darunter befindliches Silizium geätzt würde.

Ein weiterer Aspekt bei der Verwendung von ClF₃ und in eingeschränkter Maße auch BrF₃ ist die an sich geringe Reaktivität dieser hochoxidierenden Fluorverbindungen gegenüber Silizium, was dazu führt, dass eine damit durchgeführte Ätzung über einen weiteren Parameterbereich reaktionskontrolliert abläuft und nicht durch einen Stofftransport limitiert wird. Insofern können auch große Unterätzweiten realisiert werden, ohne dass eine Abnahme der Ätzrate durch ein wachsendes Aspektverhältnis der Unterätzkanäle auftritt. Beispielsweise ist es mit diesen Gasen möglich, dass die laterale Ausdehnung der Unterätzkanäle ein Vielfaches, beispielsweise 100 bis 1000, von deren vertikaler Ausdehnung ausmacht.

Schließlich erfolgt die isotrope Ätzung mit diesen Gasen völlig ohne Ioneneinwirkung, was hinsichtlich der gewünschten Isotropie und Selektivität gegenüber NichtSiliziummaterialien von großem Vorteil ist.

Insgesamt ist ClF₃ in vielerlei Hinsicht ein ideales Gas zum selektiven Entfernen von Silizium oder porösen Silizium im Rahmen einer Opferschichttechnik, so dass sich damit sehr einfach freitragende Membranstrukturen bei minimalen Einschränkungen der Designfreiheit realisieren lassen. Vielfach genügt sogar eine einzige Ätzöffnung, um eine vollständige Unterätzung eines Membranbereiches auf beispielsweise porösen Silizium zu erzielen.

Nachteilig beim Einsatz von ClF₃ und mit Einschränkung auch von BrF₃ ist andererseits, dass es sich sehr leicht umgebremst über Mikrokanalstrukturen oder sogar Nanokanalstrukturen ausbreitet, so dass die Gefahr groß ist, dass aufgebrachte Passivierschichten, beispielsweise teflonartige Seitenwandpassivierschichten gemäß DE 42 41 045 C1, über Mikro- oder Nanorisse im Grenzflächenbereich zu Silizium extrem schnell hinterkochen werden.

So hat sich gezeigt, dass eine teflonartige, aus C₄F₈ oder C₃F₆ erzeugte Plasmapassivierschicht genügend viele Mikrokanäle bzw. Nanokanäle im Grenzflächenbereich zu dem darunter befindlichen Silizium aufweist, um ausgehend von einer einzigen Einlassöffnung, beispielsweise auf dem Ätzgrund des zunächst erzeugten Trenchgrabens, die gesamte MEMS-Struktur trotz der aufgebrachten teflonartigen Passivierung großflächig einem ClF₃-Ätzagriff auszusetzen. Ein typisches Fehlerbild ist dabei, dass Strukturen, bei denen der Ätzgrund zuvor ionenunterstützt gemäß DE 42 41 045 C1 von einem passivierenden Teflonpolymer freigeräumt wurde, massiv auf der gesamten, an sich passivierten Seitenwandfläche angeätzt wird, während Strukturen, bei denen der Ätzgrund nur einen wenige Nanometer dicken Rest eines teflonartigen Polymers trägt, auch nach langer Zeit nirgends Anzeichen eines Ätzangriffes zeigen. Ursache dieses Problems sind die erläuterten Mikrokanäle bzw. Nanokanäle im Grenzflächenbereich zwischen der auf Silizium an sich schlecht haftenden Teflonpassivierung und der Siliziumoberfläche, die dem Ätzgas ClF3 Zutritt zum Silizium an unerwünschten Stellen gewähren.

Der Artikel von Ohara J. et al. : "A new deep reactive ion etching process by dual sidewall protection" PROCEEDINGS IEEE THIRTEENTH ANNUAL INTERNATIONAL CONFERENCE ON MICRO ELECTRO MECHANICAL SYSTEMS, MIYAZAKI, JAPAN, 23. - 27. Januar 2000, Seiten 277-282,beschreibt ein getaktetes Ätzverfahren, bei dem ein Passivierschichtsystem aus einer SiO2-Schicht und einer darüberliegenden Teflon-artigen Schicht gebildet wird.

Aufgabe der vorliegenden Erfindung war die Bereitstellung einer Passivierschicht auf einer Siliziumschicht sowie eines Verfahrens zur Erzeugung einer derartigen Passivier-schicht auf einer Siliziumschicht, die eine verstärkte Passivierung der Grenzfläche zwischen der Passivierschicht und der Siliziumschicht durch Vermeidung der Ausbildung oder alternativ einem Verschluss von unerwünschten mikroskaligen oder nanoskaligen Kanälen leistet, über die ansonsten ein unkontrollierter Ätzangriff, insbesondere durch ein isotrop ätzendes Gas wie ClF₃ oder BrF₃, erfolgen könnte. Daneben sollte das Verfahren und das erhaltene Schichtsystem mit der Passivierschicht in mit einer Fotolackmaskierung arbeitende Plasmaätzverfahren zur Erzeugung von Trenchgräben und freitragenden Strukturen integrierbar sei.

### Vorteile der Erfindung

Das erfindungsgemäße Schichtsystem und das erfindungsgemäße Verfahren hat gegenüber dem Stand der Technik den Vorteil, dass damit ein sehr guter Schutz einer Siliziumschicht insbesondere gegenüber einem Ätzangriff mit ClF₃ oder BrF₃ erreicht wird, und dass zumindest nahezu keine mikroskaligen oder nanoskaligen Kanäle in der Passivierschicht vorliegen, durch die eines dieser Gase die geschützte Siliziumschicht angreifen könnte. Insofern eignet sich das erfindungsgemäße Schichtsystem und das erfindungsgemäße Verfahren vor allem zum Einsatz bei der Erzeugung von zumindest weitgehend oder bereichsweise freitragenden Strukturen in Silizium, die zeitweilig eine anisotrope Ätztechnik, beispielsweise gemäß DE 42 41 045 C1, und zeitweilig eine isotrope Unterätztechnik, beispielsweise gemäß DE 44 20 962 C2 oder DE 198 47 455 A1, einsetzen.

Weiter ist vorteilhaft, dass das erfindungsgemäße Verfahren und das erfindungsgemäße Schichtsystem in Ätzprozesse integrierbar ist, die mit einer Fotolackmaske zur Erzeugung von Trenchgräben arbeiten, so dass nicht auf eine in diesen Prozessen an sich nicht erforderliche, teurere und aufwändigere Hartstoffmaskierung zurückgegriffen werden muss.

Vorteilhafte Weiterbildungen der Erfmdung ergeben sich aus den in den Unteransprüchen genannten Maßnahmen.

So ist besonders vorteilhaft, dass das Problem des Hinterkriechens des Grenzflächenbereiches zwischen der Passivierschicht und der Siliziumschicht durch eine hochoxidierende Fluorverbindung besonders wirksam dadurch verhindert werden kann, dass der Grenzflächenbereich zunächst durch eine dünne oxidische Passivierung versiegelt wird, die mit wachsender Schichtdicke prozesstechnisch in eine teflonartigen Oberflächenschicht überführt wird.

Dabei ist sicherzustellen, dass eine derartige Passivierschicht im Sinne einer kompletten Versiegelungsschicht aus Oxidschicht und darüber aufgebrachter teflonartiger Schicht einerseits alle reaktionsfähigen Bindungsplätze der Oberfläche der Siliziumschicht inertisiert und gegen den Angriff der hochoxidierenden Fluorverbindungen unempfindlich macht, und andererseits dick genug ist, um auch einem länger andauernden Ätzprozess standzuhalten.

Grundsätzlich stellt bereits eine lediglich 1 nm bis 2 nm dünne Oxidschicht, die beispielsweise aus einer Plasmaoxidation der Oberfläche der Siliziumschicht herrührt, eine geeignete Passivierung auf atomarer Ebene dar, die von hochoxidierenden Fluorverbindungen nicht hinterkrochen würde, die aber aufgrund ihrer geringen Dicke einem Ätzangriff nur kurz standhält. Insofern tritt bei dem Versuch, eine derartige, nur wenige Nanometer dicke Oxidpassivierung einer Siliziumoberfläche unmittelbar durch ein beispielsweise mit einem Plasma abgeschiedenes teflonartiges Polymer zu verstärken, insbesondere in Verbindung mit einem in der Regel unvermeidbaren Ioneneintrag auf beispielsweise Strukturseitenwände bereits eine Beschädigung der Oxidpassivierung ein.

Eine von vielen möglichen unerwünschten Ätzreaktionen in Verbindung mit dem Prozessgas C₄F₈ zur Erzeugung von teflonbildenden Monomeren verläuft dabei gemäß:

SiO₂ + (CF₂)₄ → SiF₄ + (COHCF₂)₂.

Es ist somit häufig nicht ohne Weiteres möglich, eine polymere teflonartige Schicht unmittelbar auf eine atomare Siliziumoxidpassivierung zumindest annähernd konform abzuscheiden, ohne dabei eine Beschädigung oder einen Abtrag der Oxidpassivierung in Kauf nehmen zu müssen.

Vor diesem Hintergrund ist es besonders vorteilhaft, wenn zur Versiegelung oder Passivierung der zu schützenden Siliziumschicht eine Schichtfolge eingesetzt wird, wobei zunächst eine Oxidschicht unmittelbar auf der Siliziumschicht oder einer bereits nativen oder durch Plasmaoxidation erhaltenen Siliziumoxidoberfläche mit einer Dicke von 1 nm bis 100 nm, insbesondere 5 nm bis 30 nm, abgeschieden wird, und wobei nach dem Erzeugen dieser Schicht bzw. dem Erreichen dieser Schichtdicke durch eine gezielte Variation der Prozessparameter mit weiter wachsender Dicke der Passivierschicht dann eine Schicht erzeugt wird, die sukzessive in eine teflonartige Schicht übergeht.

Diese teflonartige Schicht kann dann über den aus DE 42 41 045 C1 bekannten Depositionsprozess auf eine Schichtdicke von beispielsweise 30 nm bis 800 nm, insbesondere 50 nm bis 400 nm, verstärkt werden.

Damit hat man insgesamt vorteilhaft über einer primären dünnen Passivierung aus einer Oxidschicht eine sekundäre dicke Passivierung aus einer polymeren Schicht, insbesondere einer teflonartigen Schicht, erzeugt, welche auch lang andauernden Ätzprozessen standhalten kann, und die auch gegenüber einem Einsatz von hochoxidierenden Fluorverbindungen wie ClF₃ günstige chemische Oberflächeneigenschaften aufweist.

Besonders vorteilhaft ist weiter, wenn, wie erläutert, die zunächst aufgewachsene erste Teilschicht, insbesondere in Form einer Oxidschicht, mit fortschreitendem Schichtwachstum kontinuierlich oder in diskreten Schritten immer mehr in eine polymere Teilschicht, insbesondere die teflonartige Schicht, überführt wird.

Weiter ist vorteilhaft, dass Siliziumoxidschichten zwar üblicherweise aus einem Silan wie SiH₄ oder TEOS (Tetraethylorthosilikat) oder anderen organischen Siliziumverbindungen abgeschieden werden, welche zur Chemie der teflonbildenden, d. h. beispielsweise perfluorierten Monomere unverträglich sind, dass aus DE 197 06 682 A1 bereits ein Plasmaätzverfahren für Silizium bekannt ist, bei dem eine zu einer Fluorätzchemie verträgliche Oxidpassivierung vorgenommen wird. Dieser Prozess beruht auf einer Kombination von Siliziumtetrafluorid und Sauerstoff oder N₂O, mit deren Hilfe ein Oxidfilm auf einer Siliziumoberfläche, beispielsweise den Seitenwänden von Trenchgräben, aufbaubar ist.

Daneben ist ein derartiger Prozess nicht nur verträglich mit einer Fluorätzchemie beispielsweise gemäß DE 42 41 045 C1, d. h. freien oder in einem Plasma freigesetzten Fluorradikalen, sondern auch gegenüber teflonbildenden Monomeren. Zwar können die teflonbildenden Monomere, wie einleitend bereits erläutert, zu einem Abbau eines bereits erzeugten Siliziumoxides führen, was in DE 197 06 682 A1 durch ein kontinuierlich oder zeitweise zugesetztes Scavenger-Gas auch ausgenutzt wird, jedoch ist es möglich, die relativen Stärken der dabei ablaufenden Einzelreaktionen "Abscheidung" oder "Ätzung" durch eine geeignete Komposition des Prozessgases mit einem Teflonbildner, Siliziumtetrafluorid und einem Sauerstoffträger zu steuern. Im Übrigen ist eine gemäß DE 197 06 682 A1 mittels SiF₄ und Sauerstoff bzw. N₂O abgeschiedene dünne Siliziumoxidschicht auch zu einer Fotolackmaskierung eines Siliziumwafers kompatibel.

Daher ist ebenfalls besonders vorteilhaft, wenn eine Passivierung einer Siliziumstruktur oder Siliziumschicht zunächst mit einer Einwirkung eines Plasmas aus Siliziumtetrafluorid und einem Sauerstoffträger auf das Siliziumsubstrat beginnt, wobei das Substrat weiter bevorzugt vorausgehend einem O₂-Reinigungsschritt in einem Plasmastripper zu Entfernung von organischen Resten, beispielsweise auf Seitenwänden, und einer anschließenden Plasmaoxidation, beispielsweise von Seitenwandoberflächen, vorbehandelt wurde. Nach dieser optionalen Vorbehandlung wird dann durch eine Reaktion des Siliziumtetrafluorids mit dem Sauerstoffträger als erste Teilschicht der Passivierschicht eine Siliziumoxidschicht beispielsweise mit einer Dicke von 10 nm bis 20 nm über dem gegebenenfalls bereits vorhandenen nativen bzw. durch Plasmaoxidation erhaltenen Oberflächenoxid auf der Siliziumschicht aufgewachsen. Anschließend wird dann dem Plasma ein teflonbildende Monomere lieferndes Gas wie C₄F₈ oder C₃F₆ mit bevorzugt zunächst niedrigem Gasfluss zugegeben.

Auf diese Weise wird zunächst die Abscheidung der Siliziumoxidschicht auf der Siliziumschicht, beispielsweise auf Seitenwänden von Trenchgräben, gebremst, und danach in die im Weiteren abgeschiedene Schicht zunehmend Kohlenstoff und Fluor eingebaut.

Eine weitere, kontinuierlich oder in diskreten Schritten erfolgende Steigerung des Flusses des teflonbildende Monomere liefernden Prozessgases und eine entsprechende Reduktion des Flusses des Sauerstoffträgers oder Sauerstoffes zusammen mit dem Siliziumträger Siliziumtetrafluorid bewirkt dann, dass die abgeschiedene bzw. wachsende Schicht kontinuierlich oder in diskreten Schritten zunehmend teflonartig wird, d. h. sie weist einen allmählich abnehmenden Anteil von Silizium, SiO oder SiO₂ auf, der zudem auf vielfältige Weise mit erzeugten Teflonfadenstrukturen vernetzt wird und dabei auch teilweise carbidische Bindungen, d. h. Bindungen zwischen Silizium- und Kohlenstoff, ausbildet.

Wenn dann zuletzt nur noch ein teflonbildende Monomere lieferndes Prozessgas wie C₄F₈ oder C₃F₆ in das Plasma eingelassen wird, wächst auf der wie erläutert erzeugten Übergangsschicht schließlich ein reiner Teflonfilm bzw. ein teflonartiger Film der Struktur (-CF₂-)ₙ auf. Somit wird vermieden, dass ein abrupter Übergang von der ersten, anorganischen Teilschicht der Passivierschicht, die hier als Siliziumoxidschicht ausgebildet ist, zu der zweiten, polymeren Teilschicht der Passivierschicht, die bevorzugt als teflonartige Schicht oder Teflonschicht ausgebildet ist, auftritt. Vielmehr wird auf diese Weise ein kontinuierlicher oder gradierter Übergang der Zusammensetzung der Zwischenschicht zwischen der ersten Teilschicht und der zweiten Teilschicht erzeugt, was vor allem unter dem Aspekt einer verbesserten Haftung der teflonartigen Teilschicht auf der siliziumoxidartigen Teilschicht vorteilhaft ist.

Vorteilhaft bei dem erfindungsgemäßen Verfahren ist schließlich, dass bei der Variation der eingesetzten Prozessgase eine Vielzahl von unterschiedlichen Strategien bereit stehen, um die Eigenschaften der abgeschiedenen Schichten an die Erfordernisse des Einzelfalles anzupassen. So kann beispielsweise zunächst nur der Fluss des teflonbildenden Prozessgases langsam auf seinen Endwert gesteigert werden, während die Flüsse von Siliziumtetrafluorid und dem Sauerstoffträger, beispielsweise Sauerstoff oder N₂O, zunächst noch konstant gehalten werden, und erst danach einzeln oder in Kombination die Gasflüsse von Siliziumtetrafluorid und Sauerstoff oder Sauerstoffträger synchron oder nacheinander stufenweise oder kontinuierlich bis auf Null reduziert werden.

Die Vorteile eines gradierten Übergangs bzw. das Vorsehen einer gradierten Schicht als Zwischenschicht zwischen der ersten, anorganischen Teilschicht und der zweiten, polymeren Teilschicht liegen neben einer besonders guten Haftung oder chemischen Verbindung der Passivierschicht auf/mit der Siliziumschicht auch im Bereich einer damit erzielten, besonders effektiven Versiegelung der Siliziumschicht.

### Zeichnungen

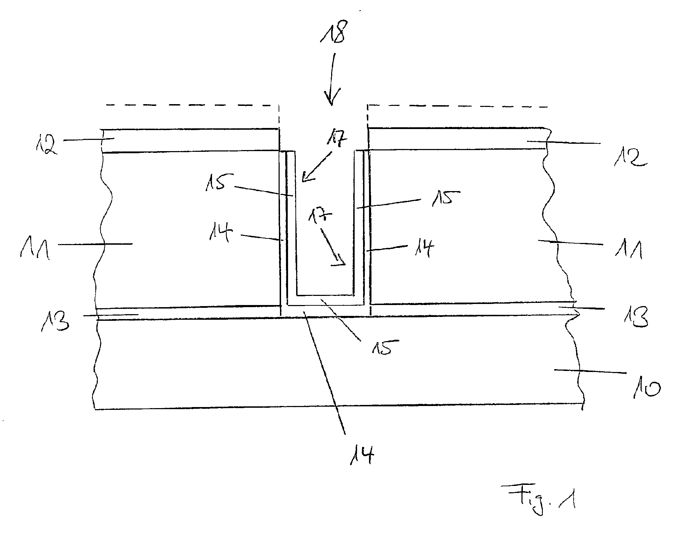

Die Erfindung wird anhand der Zeichnung und der nachfolgenden Beschreibung näher erläutert. Es zeigt Figur 1 eine Prinzipsskizze eines Schnittes durch ein Schichtsystem mit einer Strukturierung in Form eines Trenchgrabens.

### Ausführungsbeispiele

Ein Ausführungsbeispiel eines Schichtsystems mit einer Siliziumschicht und einer bereichsweise oberflächlich aufgebrachte Passivierschicht sowie das Verfahren zur Herstellung einer derartigen Passivierschicht auf einer Siliziumschicht wird mit Hilfe der Figur 1 erläutert. Insbesondere geht man zunächst von einem Siliziumwafer aus, der ein für eine Prozessierung gemäß DE 197 47 455 A1 geeignetes Schichtsystem mit vergrabenen Oxidschichten, Polysiliziumschichten und einer funktionalen Siliziumschicht trägt, auf der eine Fotolackmaskierung aufgebracht ist, die die in der Siliziumschicht zu erzeugenden Strukturen definiert.

In Figur 1 ist dazu auf einem nicht dargestellten Substrat und gegebenenfalls vorhandenen vergrabenen Oxidschichten eine erste Siliziumschicht 10 beispielsweise aus Polysilizium vorgesehen, auf der sich eine Trennschicht 13, beispielsweise aus Siliziumoxid, befindet. Auf der Trennschicht 13 ist eine zweite Siliziumschicht 11 als funktionale Siliziumschicht aufgebracht, auf der sich eine Lackmaske 12 befindet. Weiter ist in Figur 1 zu erkennen, dass mit Hilfe der Fotolackmaske 12 bereichsweise ein Trenchgraben 18 in die zweite Siliziumschicht 11 eingeätzt worden ist, der bis zu der ersten Siliziumschicht 10 reicht, d. h. dieser durchquert auch die Trennschicht 13.

Konkret wird nach einer Fotoprozessierung zur Erzeugung der Lackmaske 12 mit dem Prozess gemäß DE 42 41 045 C1 der Trenchgraben 18 in die zweite Siliziumschicht 11 eingeätzt, die beispielsweise aus einem 11 µm dicken Epipolysilizium besteht. Dieser Prozess stoppt automatisch auf der Trennschicht 13 aus einem Isolationsoxid, das gemäß der Lehre von DE 198 47 455 A1 die funktionale zweite Siliziumschiclit 11 von der ersten Siliziumschicht 10 trennt. Die Dicke der ersten Trennschicht 13 beträgt im Bereich des Trenchgrabens 18 beispielsweise 50 nm. Die zweite Siliziumschicht 11 dient beispielsweise der Erzeugung von freitragenden Strukturen darin.

Mittels eines nachfolgenden Oxidätzschrittes wird dann zunächst die Trennschicht 13 selektiv gegenüber Silizium und selektiv gegenüber der Fotolackmaskierung aus dem Trenchprozess gemäß DE 42 41 045 C1 mit Hilfe eines Plasmas durchgeätzt.

Als geeignetes, selektiv agierendes Prozessgas wird dazu beispielsweise CHF₃, C₂F₆, C₃F₆, C₄F₈ oder ein Gemisch eines dieser Gase mit CF₄ eingesetzt. Bevorzugt wird für den Oxidätzschritt C₄F₈ oder ein Gemisch von C₄F₈ mit CF₄ verwender. Der Zusatz von CF₄ dient dabei vor allem dazu, eine Polymerbildung im Plasma während der Ätzung der Trennschicht 13, d. h. von SiO₂, zu kontrollieren, wobei jedoch zu beachten ist, dass ein Zusatz von CF₄ zu einer Verschlechterung der Selektivität der Ätzung von SiO₂ gegenüber Silizium oder Fotolack führt.

Nach dem Durchätzen der Trennschicht 13 und einem relativen Stop des Ätzprozesses auf der ersten Siliziumschicht 10 werden zunächst undefinierte teflonartige Schichten auf den Seitenwänden bzw. dem Boden des Trenchgrabens 18, wie sie aus dem Prozess gemäß DE 42 41 045 C1, der zuvor durchgeführt wurde, noch vorhanden sein können, mittels einem Sauerstoffplasma entfernt. Anschließend werden die freigelegten Siliziumoberflächen kontrolliert mit einem möglichst dichten Oxid, vorzugsweise Siliziumoxid, versehen. Das initiale Oxid entsteht dabei bevorzugt bereits durch Oberflächenoxidation während der vorausgehend O₂-Plasmaentladung zur Entfernung von Polymerresten.

Hierzu wird der Wafer mit dem Schichtaufbau gemäß Figur 1 nach dem Plasmaätzschritt zum Ätzen der Trennschicht 13 zunächst einer Plasmaoxidation unterzogen, vorzugsweise in einem O₂-Plasmastripper. In dem dort vorliegenden Sauerplasma werden einerseits undefinierte teflonartige Reste entfernt, und andererseits werden darin zugängliche Siliziumoberflächen oxidiert, so dass sich ein dichtes Oberflächenoxid bildet.

Dieses "gewachsene" Oberflächenoxid auf der ersten Siliziumschicht 10 bzw. der zweiten Siliziumschicht 11 wird dann mit einem vorzugsweise unmittelbar danach darauf abgeschiedenen Siliziumoxid unter Verwendung des Prozesses gemäß DE 197 06 682 A1, d. h. mit Hilfe von SiF₄ und einem Sauerstoffträger, zunächst verstärkt. Auf diese Weise bildet sich auf den Seitenwänden der zweiten Siliziumschicht 11 bzw. auf der zugänglichen Oberfläche der ersten Siliziumschicht 10 gemäß Figur 1, auf dem darauf bereits zuvor erzeugten Oberflächenoxid (SiO₂), das in Figur 1 nicht dargestellt ist, eine erste, anorganische Teilschicht, die im erläuterten Beispiel zumindest näherungsweise aus Siliziumdioxid (SiO₂) besteht.

Im Übrigen sei erwähnt, dass während der Entfernung der teflonartigen Reste des Vorprozesses und der Oberflächenoxidation in dem Sauerstoffplasmastripper unvermeidlich auch die Lackmaske 12 teilweise mit abgetragen wird, so dass sich deren Dicke reduziert. Dies ist in Figur 1 durch eine gestrichelte Linie dargestellt, die die größere Dicke der Lackmaske 12 vor dem Zustand gemäß Figur 1 repräsentiert.

Insbesondere muss der Prozess so geführt werden, dass für den nun durchgeführten Folgeprozess noch eine ausreichend dicke Lackmaske 12 verblieben ist d. h. beispielsweise eine Lackmaske 12 mit einer Dicke von 200 nm bis 500 nm ausgehend von einer Fotolackschicht mit einer ursprünglichen Dicke von 1000 nm bis 2000 nm.

Danach wird der Wafer in einem Plasmareaktor, vorzugsweise mit einer hochdichten, induktiv gekoppelten Plasmaquelle gemäß DE 199 00 179 C1 eingebracht, wie sie für die Durchführung des Prozesses gemäß DE 42 41 045 C1 häufig benutzt wird.

Anschließend wird auf die erste anorganische Teilschicht 14 dann eine zweite, polymere Teilschicht 15 aufgebracht.

Dazu startet man beispielsweise mit einem Gasfluss des Prozessgases SiF₄ von 50 sccm (sccm = cm³/min bei Normaldruck) bis 200 sccm, beispielsweise 100 sccm, zusammen mit einem Gasfluss von Sauerstoff oder einem Sauerstoffträger wie N₂O, SO₂, NO₂, NO, CO₂, H₂O von 10 sccm bis 200 sccm, beispielsweise 50 sccm, bei einem Druck von beispielsweise 10 µbar bis 100 µbar, beispielsweise 30 µbar bis 50 µbar, in der Ätzanlage und einer Plasmaleistung von 500 Watt bis 1000 Watt an der induktiven Quelle. Die Substratelektrode wird weiter optional mit einer Hochfrequenzleistung von 5 Watt bis 50 Watt, vorzugsweise 15 Watt, polarisiert, um die zunächst abgeschiedene anorganische Teilschicht 14 durch Ioneneinwirkung zu verdichten und Fluor aus dieser auszutreiben.

Nach einer Abscheidung von beispielsweise 10 nm Siliziumoxid, was innerhalb von 30 s bis 1 min stattfindet, wird dann beispielsweise C₄F₈ oder C₃F₆ als im Plasma teflonbildende Monomere lieferndes Prozessgas zugesetzt, wobei der Gasfluss langsam, beispielsweise innerhalb von 30 s bis 5 min, bevorzugt innerhalb von einer Minute, von Null ausgehend auf einen Endgasfluss kontinuierlich oder indiskreten Schritten erhöht wird. Der Endgasfluss liegt bevorzugt im Bereich von 10 sccm bis 500 sccm, beispielsweise bei 50 sccm bis 250 sccm. Die Gasflüsse des zunächst eingesetzten SiF₄ und des Sauerstoffträgers können während der Zeitspanne innerhalb der der Teflonbildner zunehmend stärker zugeführt wird entweder synchron auf Null zurückgeführt werden, oder man lässt diese Gasflüsse zunächst konstant und führt sie dann einzeln oder zusammen auf Null zurück, nachdem der eingestellte Endgasfluss des Teflonbildners erreicht ist. Auch für dieses sogenannte "Downramping" eignen sich Zeitspannen von 30 s bis 5 min, vorzugsweise eine Minute.

Selbstverständlich ist es möglich, die vorgenannten Verfahrensweisen zu vermischen, d. h. das Hochfahren bzw. Niederfahren einzelner Gase in der Ätzkammer zu kombinieren oder unabhängig voneinander vorzunehmen, was jeweils zu einer unterschiedlichen Zusammensetzung der auf der anorganischen Teilschicht 14 erzeugten Schicht führt.

Bevorzugt ist ein synchrones Hochfahren des Gasflusses des teflonbildenden Gases und Zurückfahren des Gasflusses des Siliziumträgers und Sauerstoffträgers, wobei bevorzugt die Summe der Gasflüsse aller Prozessgase zu jedem Zeitpunkt konstant bleibt.

Beispielsweise beginnt man mit einem Fluss von 50 sccm des Sauerstoffträgers und 50 sccm des Siliziumträgers sowie 0 sccm des Teflonbildners, wobei der Gasfluss des Teflonbildners allmählich hochgefahren und der Gasfluss des Siliziumträgers und des Sauerstoffträgers allmählich zurückgefahren wird, so dass der Gasfluss aller Prozessgase in der Summe stets 100 sccm beträgt, bis zuletzt nur noch ein Gasfluss des Teflonbildners von 100 sccm vorliegt und alle anderen Gase auf einen Gasfluss von 0 sccm zurückgefahren sind. Durch diese Vorgehensweise kann auch der Prozessdruck in der Ätzkammer ohne weitere Maßnahmen annähernd konstant gehalten werden.

Nach Abschluss dieser "Ramping-Prozedur" wird die Abscheidung mit Hilfe des Teflonbildners, d. h. die Erzeugung einer Teflonschicht oder einer teflonartigen Schicht, noch für einige Minuten, beispielsweise eine Minute bis fünf Minuten, vorzugsweise zwei Minuten, fortgesetzt, wobei nur noch ein teflonartiger Film als sekundäre Passivierung über dem bereits zuvor erzeugten Schichtsystem abgeschieden wird.

Danach ist die Passivierung der Siliziumschicht 11 durch die gut haftende Passivierschicht 14, 15 abgeschlossen, die den Grenzflächenbereich zwischen der Siliziumschicht 11 und der Passivierschicht 14, 15 hinreichend gut versiegelt, um nachfolgend eingesetzten hochoxidierenden Fluorverbindungen wie ClF₃ den Zutritt zu der passivierten Siliziumschicht 11 zu verwehren, und so ein ungewolltes Hinterschneiden der Passivierschicht 14, 15 zu unterbinden.

Insgesamt wird durch das vorstehend erläuterte Verfahren auf der ersten Siliziumschicht 10, die im Bereich des Bodens des Trenchgrabens 18 zugänglich ist, sowie auf der zweiten Siliziumschicht 11, die im Bereich der Seitenwände des Trenchgrabens 18 zugänglich ist, zunächst eine optionale dünne, in Figur 1 nicht dargestellte Siliziumoxidschicht abgeschieden, auf der sich die erste, anorganische Teilschicht 14 befindet. Diese Teilschicht 14 ist bevorzugt eine Siliziumoxidschicht. Auf der ersten, anorganischen Teilschicht 14 befindet sich dann weiter eine in Figur 1 ebenfalls nicht dargestellte Zwischenschicht, die in ihrem der ersten Teilschicht 14 benachbarten Oberflächenbereich zumindest näherungsweise wie diese zusammengesetzt ist, die in ihrem der zweiten Teilschicht 15 gemäß Figur 1 benachbarten Oberflächenbereich zumindest näherungsweise wie die zweite Teilschicht 15 zusammengesetzt ist, und die in ihrer Zusammensetzung kontinuierlich oder stufenweise von der Zusammensetzung entsprechend der ersten Teilschicht 14 in die Zusammensetzung entsprechend der zweiten Teilschicht 15 übergeht. Insofern kann diese Zwischenschicht auch als Gradientenschicht bezeichnet werden. Auf der Zwischenschicht befindet sich dann schließlich die zweite, polymere Teilschicht 15 gemäß Figur 1, die bevorzugt eine Teflonschicht bzw. eine teflonartige Schicht ist, wie sie bei einem Verfahren gemäß DE 42 41 045 C2 entsteht.

Bei dem vorstehend erläuterten Schichtaufbau kann, wie angedeutet, auf die zwischen der ersten anorganischen Teilschicht 14 und der Siliziumschichten 11 bzw. 10 befindliche Siliziumoxidschicht im Übrigen auch verzichtet werden bzw. diese ist im Fall der Ausführung der anorganischen Teilschicht 14 als Siliziumoxidschicht von dieser nicht oder kaum unterscheidbar.

Zur Erzeugung einer freistehenden MEMS-Struktur wird abschließend, ausgehend von dem Stadium gemäß Figur 1, durch einen vergleichsweise kurzen Ätzschritt unter Verwendung von SF₆ oder CF₄, C₂F₆, CHF₃, C₄F₈ oder eines Gemisches aus diesen Gasen mit SF₆ als Ätzgas mit Ionenunterstützung in einem Plasma am Boden des Trenchgrabens 18 die dort vorhandene Passivierschicht 17 zunächst selektiv durchbrochen, und anschließend beispielsweise mit Hilfe von ClF₃ oder BrF₃, d. h. einer hochoxidierenden Fluorchemie, eine isotrope Unterätzung einer freizulegenden MEMS-Struktur vorgenommen. Die Unterätzung kann zeitkontrolliert sein, oder durch eine Lateralbegrenzung von vergrabenen Polysilizium-Inseln, die es zu entfernen gilt, designgesteuert werden. Nach dem Abschluss der Unterätzung wird der Wafer dann aus der Ätzkammer ausgeladen und es werden die verbliebene Lackmaske 12 und verbliebene teflonartige Teile der Passivierschicht 17 durch erneutes O₂-Plasmastrippen entfernt. Weiter können abschließend dünne Siliziumoxidschichten durch ein kurzes Überätzen in einem HF-Dampf überall dort entfernt werden, wo dies aus Gründen reduzierter mechanischer Spannungsgradienten gewünscht wird, beispielsweise auf der Unterseite einer freigelegten MEMS-Struktur.

## Patentansprüche

1. Schichtsystem mit einer Siliziumschicht, auf der zumindest bereichsweise oberflächlich eine Passivierschicht (17) zum Schutz gegenüber einem Ätzangriff aufgebracht ist, wobei die Passivierschicht (17) eine erste, zumindest weitgehend anorganische Teilschicht (14) und eine zweite, zumindest weitgehend polymere Teilschicht (15) aufweist, **dadurch gekennzeichnet, dass** innerhalb der Passivierschicht (17) zumindest bereichsweise eine zwischen der ersten Teilschicht (14) und der zweiten Teilschicht (15) befindliche, zu beiden Teilschichten (14, 15) benachbarte Zwischenschicht vorgesehen ist, wobei die Zwischenschicht eine Zusammensetzung derart aufweist, dass sie in ihrem der ersten Teilschicht (14) benachbarten Oberflächenbereich zumindest näherungsweise wie die erste Teilschicht (14) und in ihrem der zweiten Teilschicht (15) benachbarten Oberflachenbereich zumindest näherungsweise wie die zweite Teilschicht (15) zusammengesetzt ist, und wobei die Zusammensetzung der Zwischenschicht kontinuierlich oder stufenweise von der Zusammensetzung zumindest näherungsweise entsprechend der ersten Teilschicht (14) in die Zusammensetzung zumindest näherungsweise entsprechend der zweiten Teilschicht (15) übergeht.

2. Schichtsystem nach Anspruch 1, **dadurch gekennzeichnet,**
**dass** die erste Teilschicht (14) eine Dicke von 5 nm bis 100 nm und die zweite Teilschicht (15) eine Dicke von 30 nm bis 800 nm aufweist.

3. Schichtsystem nach einem der vorhergehenden Ansprüche, **dadurch gekennzeichnet, dass** die erste Teilschicht (14) zumindest weitgehend aus einer Oxidschicht, insbesondere Siliziumoxid, besteht.

4. Schichtsystem nach einem der vorhergehenden Ansprüche, **dadurch gekennzeichnet, dass** die erste Teilschicht (14) unmittelbar auf der Siliziumschicht (11) oder auf einer auf der Siliziumschicht (11) befindlichen Schicht aus Siliziumoxid aufgebracht ist.

5. Schichtsystem nach einem der vorangehenden Ansprüche, **dadurch gekennzeichnet, dass** die zweite Teilschicht (15) zumindest weitgehend eine Teflonschicht oder eine teflonartige Schicht ist.

6. Schichtsystem nach einem der vorangehenden Ansprüche, **dadurch gekennzeichnet, dass** die zweite Teilschicht (15) eine Dicke von 50 nm bis 400 nm aufweist.

7. Schichtsystem nach einem der vorangehenden Ansprüche, **dadurch gekennzeichnet, dass** die Passierschicht (17) eine die Siliziumschicht (11) gegenüber einem Ätzangriff von einem gasförmigem Halogenfluorid wie ClF₃ oder BrF₃ schützende Schicht ist.

8. Schichtsystem nach einem der vorangehenden Ansprüche, **dadurch gekennzeichnet, dass** die Passivierschicht (17) frei von mikroskaligen oder nanoskaligen, für ein Gas wie ClF₃ oder BrF₃ oder einen Dampf durchlässigen Kanälen ist.

9. Schichtsystem nach einem der vorhergehenden Ansprüche, **dadurch gekennzeichnet, dass** die Zwischenschicht Silizium, Sauerstoff, Kohlenstoff und Fluor enthält.

10. Verfahren zur Erzeugung einer Passivierschicht auf einer Siliziumschicht, insbesondere eines Schichtsystems nach einem der vorangehenden Ansprüche, wobei auf der Siliziumschicht (11) zumindest bereichsweise eine erste, zumindest weitgehend anorganische Teilschicht (14), auf der ersten Teilschicht (14) zumindest bereichsweise eine Zwischenschicht und auf der Zwischenschicht zumindest bereichsweise eine zweite, zumindest weitgehend polymere Teilschicht (15) erzeugt wird, die die Passivierschicht (17) bilden, und wobei die Erzeugung der Zwischenschicht derart erfolgt, dass die Zwischenschicht in ihrem der ersten Teilschicht (14) benachbarten Oberflächenbereich zumindest näherungsweise wie die erste Teilschicht (14) und in ihrem der zweiten Teilschicht (15) benachbarten Oberflächenbereich zumindest näherungsweise wie die zweite Teilschicht (15) zusammengesetzt ist, und dass die Zusammensetzung der Zwischenschicht kontinuierlich oder stufenweise von der Zusammensetzung zumindest näherungsweise entsprechend der ersten Teilschicht in die Zusammensetzung zumindest näherungsweise entsprechend der zweiten Teilschicht übergeht.

11. Verwendung des Schichtsystems oder des Verfahrens nach einem der vorangehenden Ansprüche bei der Erzeugung von zumindest weitgehend oder bereichsweise freitragenden Strukturen in Silizium, insbesondere mittels zeitweiligem Einsatz einer anisotropen Ätztechnik in Silizium und zeitweiligem Einsatz einer isotropen Ätztechnik in Silizium.

## Claims

1. Layer system comprising a silicon layer, on which a passivation layer (17) for protection against an etching attack is applied superficially at least in regions, the passivation layer (17) having a first, at least substantially inorganic partial layer (14) and a second, at least substantially polymeric partial layer (15), **characterized in that** an interlayer which is situated between the first partial layer (14) and the second partial layer (15) and is adjacent to both partial layers (14, 15) is provided within the passivation layer (17) at least in regions, the interlayer having a composition such that it is composed at least approximately like the first partial layer (14) in its surface region adjacent to the first partial layer (14) and at least approximately like the second partial layer (15) in its surface region adjacent to the second partial layer (15), and the composition of the interlayer undergoing transition continuously or in steps from the composition at least approximately corresponding to the first partial layer (14) to the composition at least approximately corresponding to the second partial layer (15).

2. Layer system according to Claim 1, **characterized in that** the first partial layer (14) has a thickness of 5 nm to 100 nm and the second partial layer (15) has a thickness of 30 nm to 800 nm.

3. Layer system according to any of the preceding claims, **characterized in that** the first partial layer (14) at least substantially consists of an oxide layer, in particular silicon oxide.

4. Layer system according to any of the preceding claims, **characterized in that** the first partial layer (14) is applied directly on the silicon layer (11), or on a layer of silicon oxide situated on the silicon layer (11).

5. Layer system according to any of the preceding claims, **characterized in that** the second partial layer (15) is at least substantially a Teflon layer or a Teflon-like layer.

6. Layer system according to any of the preceding claims, **characterized in that** the second partial layer (15) has a thickness of 50 nm to 400 nm.

7. Layer system according to any of the preceding claims, **characterized in that** the passivation layer (17) is a layer which protects the silicon layer (11) against an etching attack by a gaseous halogen fluoride such as ClF₃ OR BrF₃.

8. Layer system according to any of the preceding claims, **characterized in that** the passivation layer (17) is free of microscale or nanoscale channels permeable to a gas such as ClF₃ or BrF₃ or a vapour.

9. Layer system according to any of the preceding claims, **characterized in that** the interlayer contains silicon, oxygen, carbon and fluorine.

10. Method for producing a passivation layer on a silicon layer, in particular of a layer system according to any of the preceding claims, wherein a first, at least substantially inorganic partial layer (14) is produced at least in regions on the silicon layer (11), an interlayer is produced at least in regions on the first partial layer (14) and a second, at least substantially polymeric partial layer (15) is produced at least in regions on the interlayer, which form the passivation layer (17), and wherein the interlayer is produced in such a way that the interlayer is composed at least approximately like the first partial layer (14) in its surface region adjacent to the first partial layer (14) and at least approximately like the second partial layer (15) in its surface region adjacent to the second partial layer (15), and that the composition of the interlayer undergoes transition continuously or in steps from the composition at least approximately corresponding to the first partial layer to the composition at least approximately corresponding to the second partial layer.

11. Use of the layer system or of the method according to any of the preceding claims in the production of at least substantially or regionally self-supporting structures in silicon, in particular by means of temporary use of an anisotropic etching technique in silicon and temporary use of an isotropic etching technique in silicon.

## Revendications

1. Système stratifié présentant une couche de silicium dont au moins certaines parties de la surface sont recouvertes par une couche de passivation (17) qui assure la protection contre une attaque de gravure,
la couche de passivation (17) présentant une première couche partielle (14) au moins largement minérale et une deuxième couche partielle (15) au moins largement polymère,
**caractérisé en ce que**
dans au moins certaines parties de la couche de passivation (17) est prévue une couche intermédiaire voisine des deux couches partielles (14, 15) et située entre la première couche partielle (14) et la deuxième couche partielle (15),
**en ce que** la couche intermédiaire ayant une composition telle que la composition de la partie de sa surface voisine de la première couche partielle (14) est au moins approximativement identique à celle de la première couche partielle (14) et que la partie de sa surface voisine de la deuxième couche partielle (15) est au moins approximativement identique à celle de la deuxième couche partielle (15) et
**en ce que** la composition de la couche intermédiaire évolue progressivement ou par gradins depuis la composition qui correspond au moins approximativement à celle de la première couche partielle (14) jusqu'à la composition qui correspond au moins approximativement à celle de la deuxième couche partielle (15).

2. Système stratifié selon la revendication 1, **caractérisé en ce que** la première couche partielle (14) présente une épaisseur de 5 nm à 100 nm et la deuxième couche partielle (15) une épaisseur de 30 nm à 800 nm.

3. Système stratifié selon l'une des revendications précédentes, **caractérisé en ce que** la première couche partielle (14) est constituée au moins largement d'une couche d'oxyde et en particulier d'oxyde de silicium.

4. Système stratifié selon l'une des revendications précédentes, **caractérisé en ce que** la première couche partielle (14) est appliquée directement sur la couche de silicium (11) ou sur une couche d'oxyde de silicium située sur la couche de silicium (11).

5. Système stratifié selon l'une des revendications précédentes, **caractérisé en ce que** la deuxième couche partielle (15) est au moins largement une couche de téflon ou une couche de type téflon.

6. Système stratifié selon l'une des revendications précédentes, **caractérisé en ce que** la deuxième couche partielle (15) présente une épaisseur de 50 nm à 400 nm.

7. Système stratifié selon l'une des revendications précédentes, **caractérisé en ce que** la couche de passivation (17) est une couche qui protège la couche de silicium (11) vis-à-vis d'une attaque de gravure par un fluorure d'halogène gazeux, par exemple ClF₃ ou BrF₃.

8. Système stratifié selon l'une des revendications précédentes, **caractérisé en ce que** la couche de passivation (17) est exempte de canaux à échelle microscopique ou nanoscopique qui laissent passer un gaz tel que ClF₃ ou BrF₃ ou une vapeur.

9. Système stratifié selon l'une des revendications précédentes, **caractérisé en ce que** la couche intermédiaire contient du silicium, de l'azote, du carbone et du fluor.

10. Procédé de formation d'une couche de passivation sur une couche de silicium, en particulier de formation d'un système stratifié selon l'une des revendications précédentes, dans lequel une première couche partielle (14) au moins largement minérale est formée au moins sur certaines parties de la couche de silicium (11), une couche intermédiaire est formée sur au moins certaines parties de la première couche partielle (14) et une deuxième couche partielle (15) au moins largement polymère est formée sur au moins certaines parties de la couche intermédiaire, ces couches formant la couche de passivation (17),
la formation de la couche intermédiaire s'effectuant de telle sorte que dans la partie de sa surface voisine de la première couche partielle (14), la couche intermédiaire a une composition au moins approximativement identique à celle de la première couche partielle (14) et que dans la partie de sa surface voisine de la deuxième couche partielle (15), elle a au moins approximativement la même composition que la deuxième couche partielle (15) et
la composition de la couche intermédiaire évoluant de manière progressive ou par gradins depuis la composition qui correspond au moins approximativement à la première couche partielle jusqu'à la composition qui correspond au moins approximativement à la deuxième couche partielle.

11. Utilisation du système stratifié ou du procédé selon l'une des revendications précédentes dans la formation de structures au moins largement autoportantes ou autoportantes par parties dans du silicium, en particulier en recourant une partie du temps à une technique de gravure anisotrope du silicium et en recourant une partie du temps à une technique de gravure isotrope du silicium.
